# EUROPÄISCHE PATENTSCHRIFT

(11) **EP 1 927 132 B1**
(45) Veröffentlichungstag und Bekanntmachung des Hinweises auf die Patenterteilung: **11.07.2018**
(21) Anmeldenummer: 06805805.6
(22) Anmeldetag: 21.09.2006
(51) Int. Cl.: H01L 21/48, B23K 20/10, H01L 25/07, H05K 3/32, H05K 1/03, H05K 3/40, B23K 101/40

(54) **VERFAHREN ZUR HERSTELLUNG EINES LEISTUNGSHALBLEITERMODULS**
METHOD FOR THE PRODUCTION OF A POWER SEMICONDUCTOR MODULE
PROCEDE DE FABRICATION D'UNE MODULE SEMI-CONDUCTEUR DE PUISSANCE

(30) Priorität: 21.09.2005 DE 102005045100
(43) Veröffentlichungstag der Anmeldung: 04.06.2008
(73) Patentinhaber: Infineon Technologies AG, 85579 Neubiberg (DE)
(72) Erfinder: KEMPER, Alfred, 59581 Warstein (DE); STROTMANN, Guido, 59609 Anroechte (DE)
(74) Vertreter: Westphal, Mussgnug & Partner Patentanwälte mbB
(86) Internationale Anmeldenummer: PCT/EP2006/009195
(87) Internationale Veröffentlichungsnummer: WO 2007/033829

(56) Entgegenhaltungen:
- EP-A- 0 523 547
- DE-A1- 4 301 692
- DE-A1- 10 157 362
- JP-A- 2000 232 189
- JP-A- 2002 164 461
- JP-A- 2002 313 851
- JP-A- 2003 188 310
- JP-A- 2003 198 077
- US-A- 3 507 033
- US-A- 5 277 356

## Beschreibung

Vorgeschlagen wird ein Verfahren zur Herstellung eines Leistungshalbleitermoduls. Vorgeschlagen werden insbesondere das Verbinden von Stromabnahmen oder Stromanschlüssen in Leistungshalbleitermodulen mittels Ultraschallschweißen.

Beim Aufbau moderner Leistungshalbleitermodule werden zur Kontaktierung von Abschnitten einer zugrunde liegenden Leistungshalbleiterschaltung oder zu deren Kontaktierung nach außen Kontaktbereiche mit Kontaktelementen, z.B. mit bandförmigen Stromabnahmen oder Stromanschlüssen mit oder aus z.B. Kupfer, kontaktiert und verbunden. Kontakte werden dabei auf der Grundlage von Verbindungen ausgebildet, die eine vergleichsweise beschränkte Betriebstemperatur voraussetzen. Diese liegt z.B. unterhalb von 125°C. Selbst bei der Verbesserung entsprechender Lötverbindungen ist diese Betriebstemperaturgrenze nach oben hin kaum weiter auszubauen.

Aus JP-A-2003188310 ist ein Verfahren zum Herstellen eines Halbleitermoduls bekannt, bei welchem eine Leistungshalbleiterschaltung zu deren elektrischer Kontaktierung mit mindestens einem ersten Kontaktbereich ausgebildet wird, bei welchem zur elektrischen Kontaktierung der Leistungshalbleiterschaltung ferner ein Kontaktelement mit mindestens einem ersten Kontaktende ausgebildet wird, bei welchem mindestens das erste Kontaktende mit dem ersten Kontaktbereich zu einem ersten Kontakt mechanisch und elektrisch verbunden wird und bei welchem ein jeweiliger Kontakt mittels Ultraschallschweissen ausgebildet wird, wobei als Kontaktelementemassive kupferne oder primär Kupfer enthaltende Stromabnahmen verwendet werden mit einer Materialstärke im Bereich von 0,5 mm bis 1,5 mm, wobei zumindest ein Teil der Kontaktbereiche von einem Keramik-Substrat mit einer kupfernen oder primär Kupfer enthaltenden Schicht mit einer Materialstärke im Bereich von 0,1 mm bis etwa 0,5 mm gebildet wird, wobei eine Ultraschallschweissleistung im Bereich von 500 W bis 2,5 kW verwendet wird.

Weitere relevante Druckschrifte sind: DE-A-10157362 und JP-A-2002313851. Es sollen Leistungshalbleitermodule und Verfahren zu deren Herstellung angegeben werden, bei welchen auf besonders einfache und doch zuverlässige Art und Weise entsprechende Kontakte mit erweiterten Betriebstemperaturbereichen ausgebildet werden können.

Dies wird erreicht bei einem Verfahren zum Herstellen eines Leistungshalbleitermoduls mit den Merkmalen des unabhängigen Patentanspruchs 1 gelöst. Weiterbildungen des Herstellungsverfahrens für Leistungshalbleitermodule und des Leistungshalbleitermoduls sind jeweils Gegenstand der abhängigen Ansprüche.

Ein Aspekt besteht im allgemeinsten Sinn darin, bei einem Herstellungsverfahren für Leistungshalbleitermodule auszubildende Kontakte durch Ultraschallschweißen auszubilden, indem eine Sonotrode, die für den Ultraschallschweißvorgang verwendet wird, auch zum Fügen der Kontaktbereiche mit den Kontaktenden und mithin zum Fügen der Kontakte und der Fußbereiche verwendet wird.

Diese und weitere Aspekte werden auch anhand schematischer Zeichnungen näher erläutert:
- Fig. 1A: zeigt in schematischer und geschnittener Seitenansicht ein erstes Beispiel eines Leistungshalbleitermoduls.
- Fig. 1B-D: zeigen schematische Ansichten weitere Beispiele des Leistungshalbleitermoduls.
- Fig. 2: zeigt in schematischer Draufsicht eines Leistungshalbleitermoduls gemäß Fig. 1A.
- Fig. 3: zeigt in schematischer und geschnittener Seitenansicht ein Detail eines anderen Beispiels des Leistungshalbleitermoduls.
- Fig. 4: zeigt in schematischer und geschnittener Seitenansicht ein Detail eines anderen Beispiels des Leistungshalbleitermoduls.
- Fig. 5A -: 5D zeigen in schematischer und geschnittener Seitenansicht Zwischenstufen, die bei einem Verfahren zum Herstellen eines Leistungshalbleitermoduls erreicht werden.

Nachfolgend werden funktionell und/oder strukturell ähnliche oder vergleichbare Elemente mit denselben Bezugszeichen bezeichnet, ohne dass in jedem Fall ihres Auftretens eine detaillierte Beschreibung erfolgt oder wiederholt wird. Die zuvor und nachfolgend genannten Aspekte, Eigenschaften und technischen Merkmale können in beliebiger Kombination miteinander vorgesehen werden.

Es wird ein Verfahren zum Herstellen eines Leistungshalbleitermoduls mit den Merkmalen des unabhängigen Patentanspruchs 1 vorgeschlagen. Die Oberflächen Stromabnahmen oder Stromanschlüsse und der Substrate können mit oder aus Cu, Ni, NiPdAu, Pd, Ag, Sn, Zn und/oder Al ausgebildet sein.

Es können Stromabnahmen verwendet werden mit einer Materialstärke im Bereich von etwa 0,8 mm bis etwa 1,5 mm.

Es können Stromabnahmen verwendet werden mit einer Stromtragfähigkeit im Bereich von etwa 300 A bis etwa 2000 A, vorzugsweise im Bereich von etwa 300 A bis etwa 1000 A.

Es kann ein DCB-Substrat mit einer kupfernen oder primär Kupfer enthaltenden Schicht mit einer Materialstärke im Bereich von etwa 0,25 mm bis etwa 0,6 mm verwendet werden.

Die Ultraschallschweißleistung kann im Bereich von etwa 500 W bis etwa 2 kW liegen.

Die Frequenz für das Ultraschallschweißen kann im Bereich von etwa 20 kHz bis etwa 35 kHz liegen.

Die Energie für das Ultraschallschweißen kann im Bereich von etwa 50 Ws bis etwa 3 kWs liegen, vorzugsweise im Bereich von etwa 50 Ws bis etwa 800 Ws.

Die Amplitude für das Ultraschallschweißen kann im Bereich von etwa 15 µm bis etwa 50 µm liegen, vorzugsweise im Bereich von etwa 25 µm bis etwa 35 µm.

Die Schweißzeit für das Ultraschallschweißen kann im Bereich von etwa 50 ms bis etwa 2000 ms liegen, vorzugsweise im Bereich von etwa 100 ms bis etwa 500 ms.

Die ersten Kontaktenden der Kontaktelemente werden mit Energierichtungsgebern in Form von Erhebungen an den ersten Kontaktenden zur besseren Kraftausrichtung beim Ultraschallschweißen ausgebildet, und wobei die Energierichtungsgeber zumindest eines von Folgendem aufweisen:
eine Materialstärke im Bereich von etwa 0,05 mm bis etwa 0,50 mm, vorzugsweise im Bereich von etwa 0,10 mm bis etwa 0,20 mm.
einen Durchmesser im Bereich von etwa 0,5 mm bis etwa 4,0 mm, vorzugsweise im Bereich von etwa 1,0 mm bis etwa 1,5 mm.
eine Fläche im Bereich von etwa 0,2 mm² bis etwa 12,5 mm², vorzugsweise im Bereich von etwa 0,8 mm² bis etwa 1,8 mm².

Es kann vor dem eigentlichen Ultraschallschweißvorgang ein Vorgang des Kalibrierens durchgeführt werden, bei welchem mittels der Sonotrode simultan Druck auf eine Mehrzahl Kontaktenden ausgeübt wird, bis sämtliche Energierichtungsgeber mechanisch kontaktiert sind.

Das Ultraschallschweißen kann als simultaner Mehrfachschweißvorgang durchgeführt werden, bei welchem simultan eine Mehrzahl Kontaktelemente über Mehrzahl Kontaktenden kontaktiert werden, insbesondere mit jeweils einer Stromtragfähigkeit im Bereich von etwa 50 A bis etwa 500 A.

Denkbar ist dabei, dass zusätzlich vor dem eigentlichen Ultraschallschweißvorgang dabei die Sonotrode auf den Kontaktbereich abgesenkt wird, so dass dadurch das jeweilige Kontaktende unter Kraft oder Druck auf die Oberfläche des jeweiligen Kontaktbereichs angedrückt wird.

Ferner ist es zusätzlich oder alternativ denkbar, dass ein jeweiliges Kontaktelement zunächst mittels einer Halte- und Positioniervorrichtung gehaltert und positioniert wird und dann mittels der Sonotrode das Fügen und Fixieren erfolgt.

Ferner ist es bei einer Fortentwicklung des Verfahrens zum Herstellen eines Leistungshalbleitermoduls ist es vorgesehen, dass ein jeweiliges Kontaktende des Kontaktelements an einer einzigen Stelle oder an einem einzigen Punkt als einzelnem Fußbereich für die Strom- und/oder Potenzialübertragung kontaktiert wird.

Bei einer alternativen oder zusätzlichen Fortentwicklung des Verfahrens zum Herstellen eines Leistungshalbleitermoduls ist es vorgesehen, dass ein jeweiliges Kontaktende des Kontaktelements an einer Mehrzahl Stellen oder an einer Mehrzahl Punkte als Mehrzahl Fußbereiche für die Strom- und/oder Potenzialübertragung kontaktiert wird.

Bei einer weiteren alternativen oder zusätzlichen Fortentwicklung des Verfahrens zum Herstellen eines Leistungshalbleitermoduls ist es vorgesehen, dass das jeweilige Kontaktelement als ein Element aus der Gruppe ausgebildet wird, die besteht aus Kontaktdrähten, Bonddrähten, Litzen und Stanzteilen.

Bei einer alternativen oder zusätzlichen Ausgestaltungsform des Verfahrens zum Herstellen eines Leistungshalbleitermoduls ist es vorgesehen, dass das Kontaktelement mit oder aus einem Material oder einer beliebigen Kombination von Materialien aus der Gruppe ausgebildet wird, die gebildet wird von Kupfer und Aluminium.

Bei einer weiteren alternativen oder zusätzlichen Ausgestaltungsform des Verfahrens zum Herstellen eines Leistungshalbleitermoduls ist es vorgesehen, dass das Kontaktende und/oder der Kontakt mäanderförmig ausgebildet werden.

Der Kontaktbereich kann als Pad ausgebildet werden.

In der Nachbarschaft zu Kantenbereichen der Kontaktbereiche des DCB-Substrats können die ausgebildeten Kontakte einen minimalen Abstand zu den Kantenbereichen aufweisen, der in etwa der Stärke des mit dem jeweiligen Kontakt kontaktierten Kontaktendes entspricht, insbesondere im Bereich von etwa 0,5 mm bis etwa 1,5 mm.

In der Nachbarschaft zu Kantenbereichen der Kontaktbereiche des DCB-Substrats kann die geschweißte Fläche eines Kontakts einen minimalen Abstand zu den Kantenbereichen aufweisen, der in etwa der Stärke des mit dem jeweiligen Kontakt kontaktierten Kontaktendes entspricht, insbesondere im Bereich von etwa 0,5 mm bis etwa 1,5 mm.

Die geschweißte Fläche eines Kontakts kann etwa dem ein- bis dreifachen der Querschnittsfläche des jeweiligen Kontaktelements im Bereich des jeweiligen Kontaktendes entsprechen.

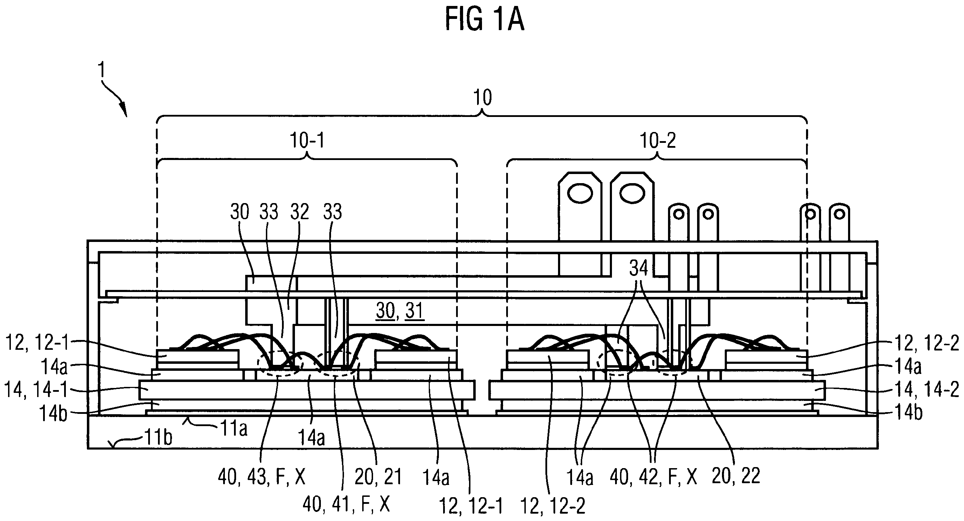

Fig. 1A ist eine schematische und geschnittene Seitenansicht eines ersten Leistungshalbleitermoduls 1. Das in Fig. 1A dargestellte Leistungshalbleitermodul 1 basiert auf einem Träger 11, z.B. aus einer Kupfer-, Aluminium- oder MMC-Bodenplatte, welche eine Oberseite 11a und eine Unterseite 11b aufweist. Auf der Oberseite 11a des Trägers 11 sind zwei Substrate oder Substratbereiche 14, 14-1 und 14, 14-2 vorgesehen, die voneinander räumlich beabstandet sind. Die Substrate oder Substratbereiche 14, 14-1, 14-2 können Metall-Keramik-Metall-Kompositmaterialien sein, z.B. DCB-Substrate.

Das erste Substrat oder der erste Substratbereich 14-1 korrespondiert mit einem ersten Schaltungsbereich 10-1 der dem Leistungshalbleitermodul 1 zugrunde liegenden Halbleiterschaltung 10, und zwar über einen vorgesehenen ersten Halbleitermaterialbereich 12, 12-1 auf dessen Oberfläche 14a und einer darin ausgebildeten entsprechenden Baugruppe, die auch aus einem einzelnen Element bestehen kann, wogegen das zweite Substrat oder der zweite Substratbereich 14, 14-2 mit einem zweiten Schaltungsbereich 10-2 der dem Leistungshalbleitermodul 1 zugrunde liegenden Halbleiterschaltung 10 korrespondiert, und zwar über einen vorgesehenen zweiten Halbleitermaterialbereich 12, 12-1 auf dessen Oberfläche 14a und einer darin ausgebildeten entsprechenden Baugruppe.

Auf den Oberseiten 14a der ersten und zweiten Substratbereiche 14, 14-1 und 14, 14-2 sind metallische Bereiche in schaltungsgerechter Art und Weise ausgebildet. Die Unterseiten 14b der ersten und zweiten Substratbereiche 14, 14-1 und 14, 14-2 sind mit metallischen Bereichen durchmetallisiert und dienen ggf. der Kontaktierung und Anbringung auf der Oberseite 11a einer Bodenplatte 11.

Auf der Oberseite 14a der Substratbereiche 14-1 und 14-2 sind verschiedene Kontaktbereiche 20, z.B. in Form von Pads oder dergleichen, vorgesehen. Auf dem ersten Substratbereich 14-1 ist ein erster Kontaktbereich 21 ausgebildet. Auf dem zweiten Trägerbereich 14-2 sind zweite und dritte Kontaktbereiche 22 bzw. 23 ausgebildet.

Zur Kontaktierung der Halbleitermaterialbereiche 12-1 und 12-2 und der entsprechenden Schaltungsbereiche 10-1 und 10-2 miteinander bzw. nach außen hin sind entsprechende Kontaktelemente 30 vorgesehen, die erste und zweite Kontaktenden 33 bzw. 34 aufweisen. So ist z.B. ein erstes Kontaktelement 31, hier in Form eines Stanzteiles als massive Stromabnahme, zur Kontaktierung der ersten und zweiten Schaltungsbereiche 10-1 und 10-2 über die ersten und zweiten Kontaktbereiche 21 bzw. 22 miteinander vorgesehen. Dabei ist das erste Kontaktende 33 des ersten Kontaktelements 31 mit dem ersten Kontaktbereich 21 auf dem ersten Substratbereich 14-1 elektrisch oder mechanisch kontaktiert, wogegen das zweite Ende 34 des ersten Kontaktelements 31 auf dem zweiten Kontaktbereich 22 auf dem zweiten Substratbereich 14-2 kontaktiert ist.

Auf diese Art und Weise werden jeweils Kontakte 40 gebildet, nämlich ein erster Kontakt 41 im Bereich des ersten Kontaktbereichs 21 mit dem ersten Kontaktende 33 des ersten Kontaktelements 31 auf der Oberfläche 14a des ersten Substratbereichs 14-1 und ein zweiter Kontakt 42 im Bereich des zweiten Kontaktbereichs 22 auf dem zweiten Substratbereich 12-2 unter Verwendung des zweiten Kontaktendes 34 des ersten Kontaktelements 31 auf der Oberfläche 14a des zweiten Substratbereichs 14-2.

Das zweite Kontaktelement 32 dient einer anderen Form der Kontaktierung des ersten Schaltungsbereichs 10-1, nämlich durch Ausbildung eines dritten Kontakts 43 im Bereich des ersten Kontaktbereichs 21 des ersten Substratbereichs 14-1, wobei das erste Kontaktende 33 des zweiten Kontaktelements 32 auf dem ersten Kontaktbereich 21 auf der Oberfläche 14a des ersten Substratbereichs 12-2 kontaktiert ist.

Die so ausgebildeten Kontakte 40 - 43 liegen als Ultraschallschweißkontakte vor.

Das Leistungshalbleitermodul 1 kann auch auf der Grundlage nur eines zusammenhängenden Halbleitermaterialbereichs 12 oder mit einer höheren Mehrzahl Halbleitermaterialbereiche 12 ausgebildet sein. Es können des Weiteren mehr oder weniger Kontaktbereiche 20 vorgesehen sein, als in der Fig. 1A dargestellt ist.

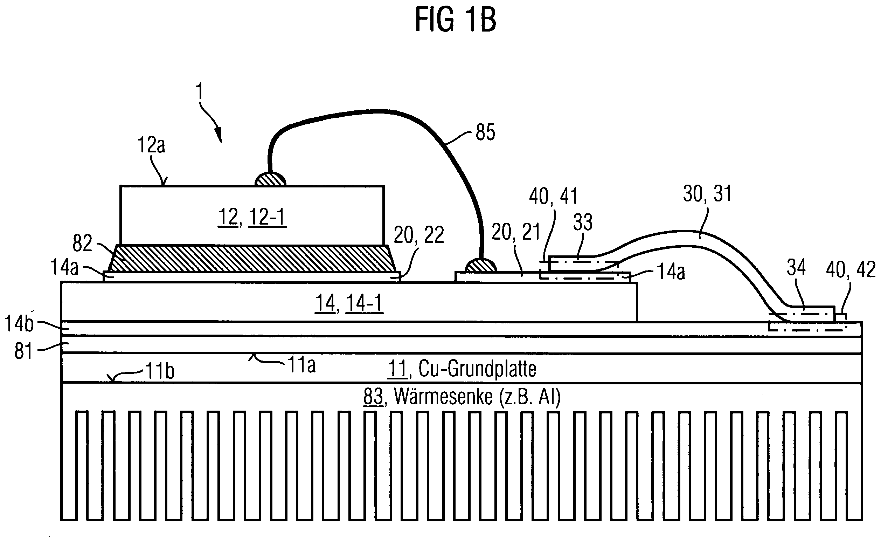

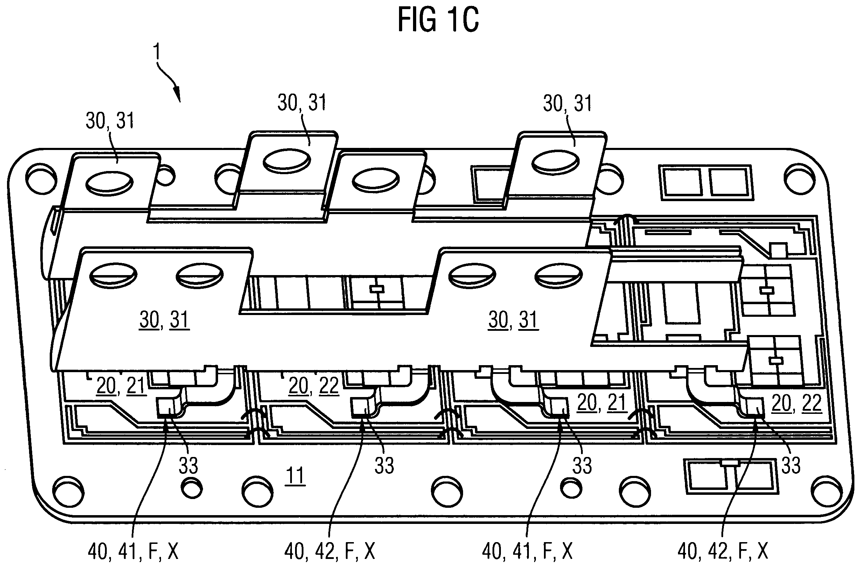

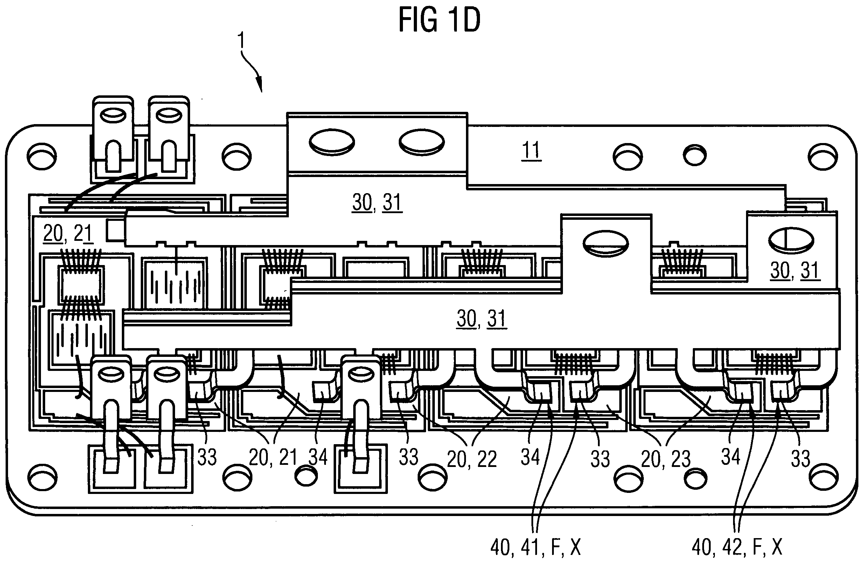

Die Figuren 1B bis 1D zeigen andere Beispiele des Leistungshalbleitermoduls 1, wobei die Kontaktelemente 30, 31, 32 jeweils als so genannte Stromabnahmen konzipiert sind und - bei den Beispielen gemäß Fig. 1C und 1D - über eine Mehrzahl Kontaktenden 33, 34 auch eine Mehrzahl Kontakte 40, 41, 42, 43 realisieren können, wobei diese simultan ausgebildet werden können.

In Fig. 1B ist der Träger 11 als Grundplatte mit seiner Unterseite 11b auf einem Kühlkörper als Wärmesenke 83 angeordnet. Auf der Oberseite 11a des Trägers ist über eine erstes Lotmittel 81 der Substratbereich 14, 14-1, z.B. ein DCB-Substrat, vorgesehen, dessen Unterseite 14b eine durchgehende Metallisierung ist und dessen Oberseite 14a eine schaltungsgerecht strukturierte Metallisierung ist.

Auf der linken Seite der Oberseite 14a des Substratbereichs 14, 14-1 ist über eine zweites Lotmittel 82mit seiner Unterseite 12b eine Halbleitermaterialbereich 12, 12-1 oder Chip mit einer darin enthaltenen Halbleiterschaltung 10 vorgesehen. Die Oberseite 12a des Halbleitermaterialbereichs 12, 12-1 ist über einen Bonddraht 85 mit einem rechts angeordneten Teil der metallischen Oberseite 14a des Substratbereichs 14, 14-1 kontaktiert, durch welchen ein Kontaktbereich 20, 21 gebildet wird. Auf diesem Kontaktbereich 20, 21 ist über einen ersten Kontakt 40, 41 und ein erstes Kontaktende 33 ein Kontaktelement 30, 31 in Form einer massiven Stromabnahme angeschlossen und führt über ein zweites Kontaktende 34 zu einem zweiten Kontakt 40, 42, der von einem frei gelegten Teil der Metallisierung der Unterseite 14b des Substratbereichs 14, 14-1 gebildet wird.

Die Fig. 1C und 1D zeigen in perspektivischer Draufsicht zwei andere Beispiele des Leistungshalbleitermoduls 1, wobei neben Kontaktelementen mit nur einem Kontaktende jeweils auch mehrere Kontaktelemente 30, 31, 32 in Form massiver Stromabnahmen mit jeweils einer Mehrzahl Kontaktenden 33, 34 zur Ausbildung einer Mehrzahl Kontakte 40 - 43 oder Fußpunkte F an verschieden Stellen X vorgehen sind, die insbesondere simultan über fügendes Ultraschallschweißen ausgebildet werden.

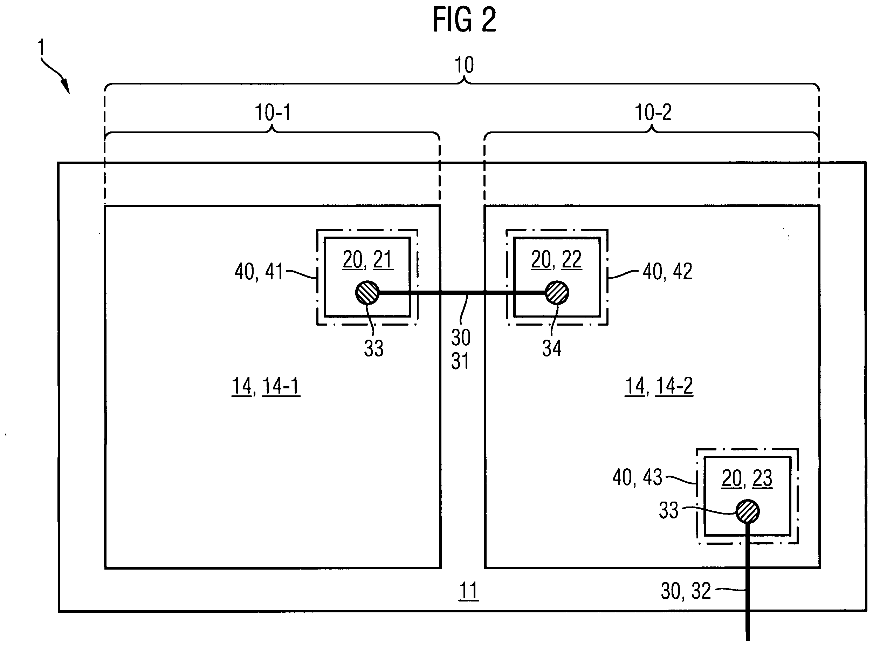

Fig. 2 ist eine schematische Draufsicht auf ein anderes Beispiel des Leistungshalbleitermoduls 1. Die einzelnen Schaltungsbereiche 10-1 und 10-2 sind hier nicht im Detail gezeigt, vielmehr wird auf die Kontaktbereiche 20, 21, 22, 23 auf den Substratbereichen 14, 14-1, 14-2 eingegangen. Das in Fig. 2 dargestellte Leistungshalbleitermoduls 1 basiert wieder auf einem Träger 11, aus einer kupfernen Grundplatte, welche eine Oberseite 11a und eine Unterseite 11b aufweist. Auf der Oberseite 11a des Trägers 11 sind in dem in Fig. 2 dargestellten Beispiel zwei Substratbereiche 14, 14-1, 14-2 vorgesehen, die voneinander räumlich beabstandet sind. Der erste Substratbereich 14-1 korrespondiert mit einem ersten Schaltungsbereich 10-1 der dem Leistungshalbleitermodul 1 zugrunde liegenden Halbleiterschaltung 10, wogegen der zweite Substratbereich 14-2 mit einem zweiten Schaltungsbereich 10-2 der dem Leistungshalbleitermodul 1 zugrunde liegenden Halbleiterschaltung 10 korrespondiert.

Die Substratbereiche 14-1 und 14-2 besitzen ihrerseits ebenfalls jeweils eine Oberseite 14a und eine Unterseite 14b. Somit ist jeweils die Unterseite 14b des jeweiligen Substratbereichs 14, 14-1, 14-2 auf der Oberseite 11a des zugrunde liegenden Trägers 11 aufgebracht.

Auf der Oberseite 14a der Substratbereiche 14-1 und 14-2 sind verschiedene Kontaktbereiche 20, z.B. in Form von Pads oder dergleichen, vorgesehen. Auf dem ersten Substratbereich 14-1 ist ein erster Kontaktbereich 21 ausgebildet. Auf dem zweiten Substratbereich 14-2 sind zweite und dritte Kontaktbereiche 22 bzw. 23 ausgebildet.

Zur Kontaktierung der Substratbereiche 14-1 und 14-2 und ggf. der entsprechenden Schaltungsbereiche 10-1 und 10-2 nach außen hin sind entsprechende Kontaktelemente 30 vorgesehen, die erste und zweite Kontaktenden 33 bzw. 34 aufweisen. So ist z.B. ein erstes Kontaktelement 31 zur Kontaktierung der ersten und zweiten Substratbereiche 14-1 und 14-2 über die ersten und zweiten Kontaktbereiche 21 bzw. 22 miteinander vorgesehen. Dabei ist das erste Kontaktende 33 des ersten Kontaktelements 31 mit dem ersten Kontaktbereich 21 auf dem ersten Substratbereich 14-1 elektrisch und mechanisch kontaktiert, wogegen das zweite Ende 34 des ersten Kontaktelements 31 auf dem zweiten Kontaktbereich 22 auf dem zweiten Substratbereich 14-2 kontaktiert ist. Auf diese Art und Weise werden wieder Kontakte 40 gebildet, nämlich ein erster Kontakt 41 im Bereich des ersten Kontaktbereichs 21 mit dem ersten Kontaktende 33 des ersten Kontaktelements 31 auf dem ersten Substratbereich 14-1 und ein zweiter Kontakt 42 im Bereich des zweiten Kontaktbereichs 22 auf dem zweiten Substratbereich 14-2 unter Verwendung des zweiten Kontaktendes 34 des ersten Kontaktelements 31.

Das zweite Kontaktelement 32 dient der externen Kontaktierung der gesamten Halbleiterschaltung 10, nämlich durch Ausbildung eines dritten Kontakts 43 im Bereich des dritten Kontaktbereichs 23 des zweiten Substratbereichs 12-2, wobei das erste Kontaktende 33 des zweiten Kontaktelements 32 auf dem dritten Kontaktbereich 23 auf der Oberfläche 14a des zweiten Substratbereichs 14-2 kontaktiert ist. Das zweite Kontaktelement 32 verläuft dann vom eigentlichen Leistungshalbleitermodul 1 fort nach extern.

Die Kontakte 40 - 43 werden wieder als Ultraschallschweißkontakte ausgebildet.

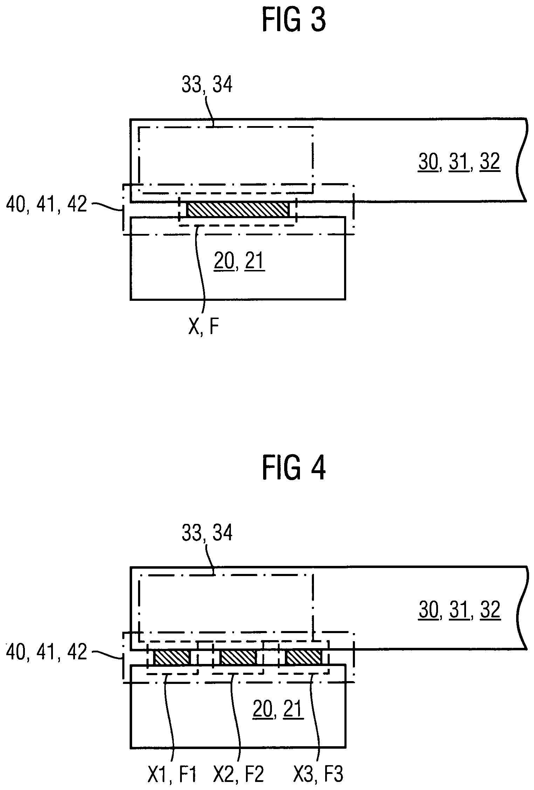

Fig. 3 zeigt in schematischer und geschnittener Seitenansicht die durch Ultraschallschweißung ausgebildeten Kontakte 40 - 43 zwischen einem Kontaktelement 30 - 32 und einem Kontaktbereich 20 - 22. Beim Verfahren gemäß Fig. 3 wird dabei durch Ultraschallschweißung an einer einzelnen und einzigen Stelle X zwischen dem ersten oder zweiten Kontaktende 32 bzw. 34 des Kontaktelements 30 - 32 ein einziger Fußbereich F für die Übertragung von Strom und/oder Potenzial ausgebildet. Beim Verfahren gemäß Fig. 4 dagegen werden durch Ultraschallschweißung bei der Herstellung der Kontakte 40 - 42 an mehreren Punkten oder Stellen, nämlich an drei Punkten oder Stellen X1, X2 und X3, eine entsprechende Mehrzahl Fußbereiche F1, F2 und F3 für die Übertragung von elektrischem Strom und/oder elektrischem Potenzial ausgebildet.

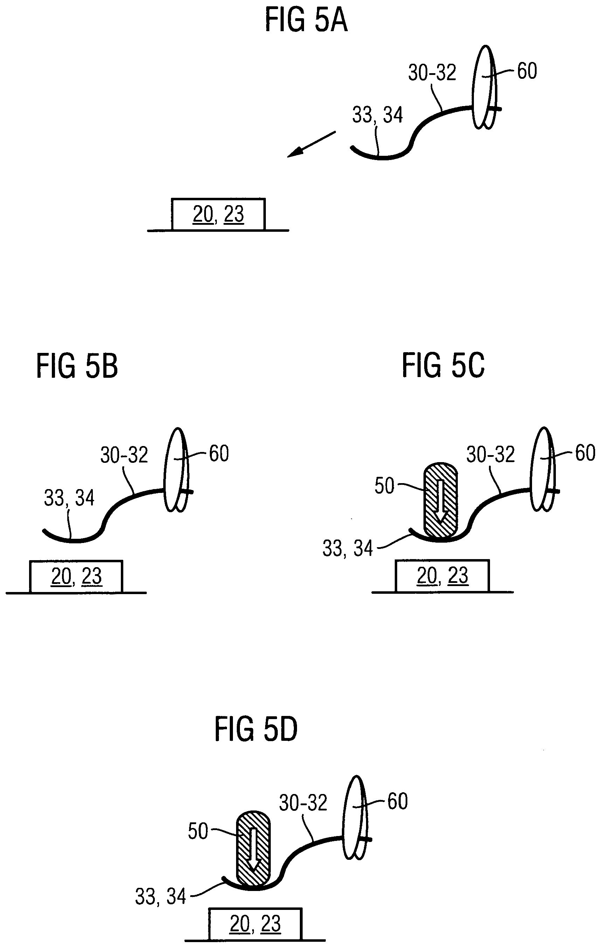

Die Fig. 5A bis 5D zeigen in schematischer und geschnittener Seitenansicht Zwischenstufen, die bei einem Verfahren zum Herstellen eines Leistungshalbleitermoduls erreicht werden.

Wie in Fig. 5A dargestellt ist, wird zunächst ein Kontaktelement 30 - 32 bereitgestellt, z.B. in Form eines Stanzteils oder in Form eines Bonddrahts oder dergleichen. Dazu wird das Kontaktelement 30 - 32 mittels einer Halte- und Positioniervorrichtung 60 ergriffen und durch Positionieren entsprechend an einen Kontaktbereich 20 - 23 herangeführt.

Dadurch wird der in Fig. 5B gezeigte Zwischenzustand erreicht, bei welchem das Kontaktelement 30 - 32 derart positioniert ist, dass das entsprechende Kontaktende 33, 34 des Kontaktelements 30 - 32 kurz oberhalb des Kontaktbereichs 20 - 23 angeordnet ist, dieses mit dem Kontaktende 33, 34 aber nicht unbedingt zu berühren braucht.

Im Übergang zu dem in Fig. 5C gezeigten Zwischenzustand wird dann unter unveränderter Positionierung des Kontaktelements 30 - 32 mittels der Halte- und Positioniervorrichtung 60 eine Sonotrode 50 an das Kontaktende 33, 34 des Kontaktelements 30 - 32 derart herangeführt, dass dadurch ein Bereich des Kontaktendes 33, 34 berührt und unter Kraftaufwand oder durch Druck, die durch den weißen Pfeil dargestellt sind, auf den Kontaktbereich 20 - 23 zu bewegt wird.

Dies geschieht in einer Art und Weise, dass sich der in Fig. 5D gezeigte Zwischenzustand einstellt, bei welchem durch den Kraftaufwand oder unter Druck durch die Sonotrode 50 das Kontaktende 33, 34 des Kontaktelements 30 - 32 in mechanischem und elektrischem Kontakt mit der Oberfläche des Kontaktbereichs 20 - 23 steht. In dem in Fig. 5D gezeigten Zwischenzustand wird dann auch die Sonotrode 50 zum Ultraschallschweißen aktiviert, um dann den entsprechenden Kontakt 40 - 43 zwischen dem Kontaktbereich 20 - 23 und dem Kontaktende 33, 34 als Ultraschallschweißkontakte auszubilden.

Das gemäß den Fig. 5A bis 5D dargestellte Vorgehen hat den Vorteil, dass sämtliche Formen von Kontaktelementen 30 - 32 verarbeitet und kontaktiert werden können.

Es kann sich dabei um Kontaktelemente 30 - 32 handeln, die eine externe Kontaktierung eines Halbleitermoduls 1 nach außen realisieren und somit nur mit einem einzigen Kontaktende 33 im Bereich der Halbleiterschaltungsanordnung 10 kontaktiert werden oder sind. Es kann sich aber auch um interne Kontaktelemente 30, 31 handeln, die unterschiedliche Halbleiterschaltungsbereiche 10-1 und 10-2 innerhalb eines Gehäuses des Moduls miteinander kontaktieren.

Im Gegensatz zu bekannten Herstellungsverfahren ist hier also eine externe Fixierung der zu kontaktierenden Kontaktelemente 30 - 32, z.B. im Bereich eines Gehäuserahmens oder im Bereich einer Vergussmasse, nicht notwendig. Dies ergibt sich aus dem Umstand, dass hier die Sonotrode 50 selbst zur mechanischen Endpositionierung der Kontaktenden 33, 34 durch Andruck auf die Oberfläche der zu kontaktierenden Kontaktbereiche 20 - 23 eingesetzt wird, wobei gleichzeitig also ein entsprechender Fügeprozess zwischen den zu fügenden Einzelteilen, nämlich den Kontaktelementen 30 - 32 einerseits und den Kontaktbereichen 20 - 23 andererseits, erfolgt.

Diese und weitere Aspekte werden auch anhand der nachstehenden Bemerkungen mit anderen Worten näher erläutert:
Vorgeschlagen wird unter anderem auch die Verbindung von Stromabnahmen in Leistungshalbleitermodulen mittels Ultraschallschweißen.

Bei dem Aufbau von Leistungshalbleitermodulen werden zur Stromführung von der Keramik zu den Außenanschlüssen und auf den Keramiken untereinander elektrisch leitende Verbindungen benötigt. Hier werden thermisch wechsellastfeste Verbindungen gesucht, die eine Betriebstemperatur von 200°C ermöglichen. Die Kontaktierung dieser Verbindungen wird z.B. mittels Lötverbindung oder Bondtechnik ausgeführt die damit auf eine Betriebstemperatur von 125°C begrenzt ist.

Die Lötverbindungen werden z.B. unter zu Hilfenahme von Lötvorrichtungen in einem Lötofen (Durchlauf- oder Batchofen ggf. mit Vakuum) durchgeführt. Während des Lötprozesses bewegt sich die Stromabnahme beim Aufschmelzen des Lotes in Richtung Substrat oder das Lot fließt aus einem Depot zu. Dabei kann sich aufgrund der Toleranzen (Bauteiltoleranzen allgemein, Wärmeausdehnungen, Änderung von Durchbiegungen) eine gleiche Schichtdicke des Lotes bzw. Auflage nur an zwei Punkten der Stromabnahme (zwei Fußpunkte) einstellen. Bei zwei Lötpunkten pro Stromabnahme ist eine gleichmäßige Lotschichtdicke schon nicht immer einzuhalten, bei mehr als zwei Lötpunkten ist eine gleichmäßige Lotschicht nicht erreichbar und die Zuverlässigkeit der Verbindung wird unter Umständen stark beeinflusst.

Weiterhin können Verbindungen zwischen Substraten untereinander und von Substraten zu im Gehäuse eingespritzten oder eingesteckten Stromabnahmen mittels Al-Drähten und Bondtechnik hergestellt werden. Die hier beherrschten Ströme sind aufgrund der Querschnitte der Alu Drähte und damit der damit verbundenen Stromtragfähigkeit sowie der zur Verfügung stehenden Flächen begrenzt.

Die Lötverbindung selbst ist im Rahmen von thermischen Wechsellasten auf eine Betriebstemperatur max. 125°C begrenzt. Eine Betriebstemperatur von 200°C, besonders von Automotive-Anwendern gefordert, ist mit Lötverbindungen nicht erreichbar.

Weiterhin erhöht sich mit steigender Lotschicht der elektrische Widerstand der Verbindung und damit wieder die thermische Belastung im Betrieb. Generell nimmt die mechanische Festigkeit einer Lötverbindung mit steigender Temperatur stark ab.

Mit dem Ultraschallschweißverfahren werden metallische stoffschlüssige Verbindungen geschaffen die auch bei einer Betriebstemperatur von 200°C im thermischen Wechsellastverhalten stabil sind. Die elektrischen Übergangswiderstände an den Verbindungspunkten sind gegenüber den Lötverbindungen absolut gleichmäßig und sehr klein. Dies wird erreicht durch die stoffschlüssigen Verbindung der Ultraschallschweißung der beiden Kontaktpartner. Ein weiterer großer Vorteil ist die deutlich bessere Automatisierbarkeit des Ultraschallprozesses gegenüber Lötprozessen in Vakuumöfen.

Es wird ein Weg aufgezeigt, wie die Kontaktstellen sicher gefügt werden - unabhängig davon, ob es sich um ein, zwei oder mehrere Kontaktstellen einer Stromabnahme handelt. Die Kontaktstellen der Stromabnahme können sich auf einem oder mehreren Substrate oder dem Gehäuse befinden. Die Dickentoleranz der Substrate oder konstruktiv bedingte Höhenunterschiede der Kontaktstellen bereiten hierbei im Vergleich zum Löten keine Probleme.

Es wird vorgeschlagen, die Sonotrode der Schweißanlage zum Fügen der Füße der Stromabnahme vor dem eigentlichen Schweißvorgang zu nutzen. D.h., die Sonotrode senkt sich im Schweißprozess auf den zu schweißenden Fuß der Stromabnahme ab und drückt ihn kraftabhängig bis Kontakt zum Substrat hergestellt ist. Der Fuß der Stromabnahme ist so konstruiert, dass er über eine Art Mäander verfügt um Ausdehnungen des Moduls im Betrieb zu erlauben (wie auch im Betrieb eines Leistungshalbleitermoduls nötig). Dann erfolgt der eigentliche Fügeprozess mittels Ultraschallschweißen.

Beim Lötprozess werden die Stromabnahmen in relativ komplizierten Lötformen schwimmend so vormontiert, dass sie sich im Löt- und Abkühlprozess bewegen und in das flüssige Lot nachrutschen können.

Beim Ultraschallschweißen werden die Stromabnahmen fest in einer Vorrichtung eingespannt oder mittels Handling an die Schweißstelle gebracht. Eine Bewegung und Nachrutschen der gesamten Stromabnahme ist im Gegensatz zum Löten nicht erforderlich. Hierdurch ist es möglich, auch Fügesituationen zu realisieren die mit einem Lötprozess in Lötformen nicht machbar sind.

Stoffschlüssige Verbindung von einem oder mehreren Kontaktpunkten einer Stromführung in einem Modul. Diese Stromführungen können sowohl in den Gehäusewänden eingespritzt als auch frei im Modul auf die Keramik Substrate geschweißt werden. Es können Kupfer - Kupfer Verbindungen und auch andere metallische Verbindungen verschweißt werden.

Die Verbindung dieser Kontaktpunkte geschieht durch Kaltverschweißen bei Raumtemperatur, dadurch treten keine thermische Belastung der Bauteile bei den Verbindungen der Fußpunkte auf.

Gleichmäßige Übergangswiderstände an den Kontaktstellen sind auch bei mehreren Fußpunkten möglich, dadurch sind unterschiedliche elektrische Übergangswiderstände wie beim Löten vermeidbar.

Es ist ein toleranzunabhängiges Fügen und Verbinden von einem oder mehreren Fußpunkten möglich. Durch dieses Verfahren sind auch Verbindungen in einem Leistungshalbleitermodul auf verschiedenen Montageebenen mittels unterschiedlichen Stromführungen wie z.B. flexible Litze, Drähte, Stanzteile usw. möglich. Hierdurch ergeben sich völlig neue Verschaltungsmöglichkeiten in horizontaler und vertikaler Ausdehnung die mit Lötverfahren nicht zu realisieren sind.

Auch das Erzeugen von temperaturfesten Schaltungen mittels Hochstromverbindungen in einem Leistungshalbleitermodul ist möglich.

Diese Kontaktpunkte können auch in einem nicht hochwarmfesten Kunststoffgehäuse liegen, weil dieses keinem Warmprozess, wie z. B. dem Löten, mehr unterzogen wird. Der Montageablauf eines Halbleitermoduls wird gegenüber dem Löten durch die nicht mehr erforderliche Erwärmung erheblich vereinfacht und wird deutlich flexibler.

Es können z.B. sechs Fußpunkte pro Stromabnahme auf verschiedene Substrate geschweißt werden. Die vorliegenden Höhentoleranzen können durch das Fügen mit der Sonotrode vor dem Schweißen kompensiert.

### Bezugszeichenliste

- 1: Ausführungsform eines Leistungshalbleitermoduls
- 10: Halbleiterschaltungsanordnung, Halbleiterschaltung, Leistungshalbleiterschaltungsanordnung, Leistungshalbleiterschaltung
- 10-1: Schaltungsbereich, erster Schaltungsbereich
- 10-2: Schaltungsbereich, zweiter Schaltungsbereich
- 11: Träger, Kupferbodenplatte, Aluminiumbodenplatte, MMC-Bodenplatte
- 11a: Oberseite
- 11b: Unterseite
- 12: Halbleitermaterialbereich
- 12a: Oberseite
- 12b: Unterseite
- 12-1: erster Halbleitermaterialbereich
- 12-2: zweiter Halbleitermaterialbereich
- 14: Substratbereich, Substrat, DCB-Substrat
- 14a: Oberseite
- 14b: Unterseite
- 14-1: erster Substratbereich, erstes Substrat
- 14-2: zweiter Substratbereich, zweites Substrat
- 20: Kontaktbereich
- 21: erster Kontaktbereich
- 22: zweiter Kontaktbereich
- 23: dritter Kontaktbereich
- 30: Kontaktelement
- 31: erstes Kontaktelement
- 32: zweites Kontaktelement
- 33: erstes Kontaktende
- 34: zweites Kontaktende
- 40: Kontakt
- 41: erster Kontakt
- 42: zweiter Kontakt
- 43: dritter Kontakt
- 50: Sonotrode
- 60: Halte- und Positioniervorrichtung
- 81: erstes Lotmittel
- 82: zweites Lotmittel
- 83: Wärmesenke, Kühlkörper
- 85: Bonddraht

- F: Fußbereich
- F1 - F3: Fußbereich
- X: Punkt, Stelle
- X1 - X3: Punkt, Stelle

## Patentansprüche

1. Verfahren zum Herstellen eines Leistungshalbleitermoduls (1),
- bei welchem eine Leistungshalbleiterschaltung (10) zu deren elektrischer Kontaktierung mit mindestens einem ersten Kontaktbereich (20 - 23) ausgebildet wird,
- bei welchem zur elektrischen Kontaktierung der Leistungshalbleiterschaltung (10) ferner ein Kontaktelement (30 - 32) mit mindestens einem ersten Kontaktende (33, 34) ausgebildet wird,
- bei welchem mindestens das erste Kontaktende (33, 34) mit dem ersten Kontaktbereich (20 - 23) zu einem ersten Kontakt (40 - 43) mechanisch und elektrisch verbunden wird, und
- bei welchem ein jeweiliger Kontakt (40 - 43) mittels Ultraschallschweißen ausgebildet wird,
- indem eine Sonotrode (50), die für den Ultraschallschweißvorgang verwendet wird, auch zum Fügen der Kontaktende (33, 34) mit den Kontaktbereichen (20 - 22) und mithin zum Fügen der Kontakte (40, 42) verwendet wird, wobei als Kontaktelemente (30 - 32) massive kupferne oder primär Kupfer enthaltende Stromabnahmen verwendet werden mit einer Materialstärke im Bereich von etwa 0,1 mm bis etwa 3,0 mm und mit einer Stromtragfähigkeit im Bereich von etwa 50 A bis etwa 2000 A,
- wobei zumindest ein Teil der Kontaktbereiche (20 - 22) von einem DCB-Substrat mit einer kupfernen oder primär Kupfer enthaltenden Schicht mit einer Materialstärke im Bereich von etwa 0,1 mm bis etwa 1,0 mm gebildet wird,
- wobei eine Ultraschallschweißleistung im Bereich von etwa 300 W bis etwa 10 kW verwendet wird,
- wobei als Fügekraft eine Normalkraft auf oder für die Sonotrode im Bereich von etwa 500 N bis etwa 3500 N verwendet wird,
- wobei die ersten Kontaktenden (33, 34) der Kontaktelemente (30 - 32) mit Energierichtungsgebern in Form von Erhebungen an den ersten Kontaktenden (33, 34) zur besseren Kraftausrichtung beim Ultraschallschweißen ausgebildet werden, und wobei die Energierichtungsgeber zumindest eines von Folgendem aufweisen:
eine Materialstärke im Bereich von etwa 0,05 mm bis etwa 0,50 mm, vorzugsweise im Bereich von etwa 0,10 mm bis etwa 0,20 mm;
einen Durchmesser im Bereich von etwa 0,5 mm bis etwa 4,0 mm, vorzugsweise im Bereich von etwa 1,0 mm bis etwa 1,5 mm;
eine Fläche im Bereich von etwa 0,2 mm² bis etwa 12,5 mm², vorzugsweise im Bereich von etwa 0,8 mm² bis etwa 1,8 mm².

2. Verfahren nach Anspruch 1,
wobei Stromabnahmen verwendet werden mit einer Materialstärke im Bereich von etwa 0,8 mm bis etwa 1,5 mm.

3. Verfahren nach einem der vorangehenden Ansprüche,
wobei Stromabnahmen verwendet werden mit einer Stromtragfähigkeit im Bereich von etwa 300 A bis etwa 2000 A, vorzugsweise im Bereich von etwa 300 A bis etwa 1000 A.

4. Verfahren nach einem der vorangehenden Ansprüche, wobei ein DCB-Substrat mit einer kupfernen oder primär Kupfer enthaltenden Schicht mit einer Materialstärke im Bereich von etwa 0,25 mm bis etwa 0,6 mm verwendet wird.

5. Verfahren nach einem der vorangehenden Ansprüche,
wobei die Ultraschallschweißleistung im Bereich von etwa 500 W bis etwa 2 kW liegt.

6. Verfahren nach einem der vorangehenden Ansprüche,
wobei die Frequenz für das Ultraschallschweißen im Bereich von etwa 20 kHz bis etwa 35 kHz liegt.

7. Verfahren nach einem der vorangehenden Ansprüche,
wobei die Energie für das Ultraschallschweißen im Bereich von etwa 50 Ws bis etwa 3 kWs liegt, vorzugsweise im Bereich von etwa 50 Ws bis etwa 800 Ws.

8. Verfahren nach einem der vorangehenden Ansprüche,
wobei die Amplitude für das Ultraschallschweißen im Bereich von etwa 15 µm bis etwa 50 µm liegt, vorzugsweise im Bereich von etwa 25 µm bis etwa 35 µm.

9. Verfahren nach einem der vorangehenden Ansprüche,
wobei die Schweißzeit für das Ultraschallschweißen im Bereich von etwa 50 ms bis etwa 2000 ms liegt, vorzugsweise im Bereich von etwa 100 ms bis etwa 500 ms.

10. Verfahren nach einem der vorangehenden Ansprüche,
bei welchem vor dem eigentlichen Ultraschallschweißvorgang ein Vorgang des Kalibrierens durchgeführt wird, bei welchem mittels der Sonotrode (50) simultan Druck auf eine Mehrzahl Kontaktenden (33, 34) ausgeübt wird, bis sämtliche Energierichtungsgeber mechanisch kontaktiert sind.

11. Verfahren nach einem der vorangehenden Ansprüche,
bei welchem das Ultraschallschweißen als simultaner Mehrfachschweißvorgang durchgeführt wird, bei welchem simultan eine Mehrzahl Kontaktelemente (30 - 32) über Mehrzahl Kontaktenden (33, 34) kontaktiert werden, insbesondere mit jeweils einer Stromtragfähigkeit im Bereich von etwa 50 A bis etwa 500 A.

12. Verfahren nach einem der vorangehenden Ansprüche,
bei welchem vor dem eigentlichen Ultraschallschweißvorgang die Sonotrode (50) auf den Kontaktbereich (20 - 22) abgesenkt wird, so dass dadurch das jeweilige Kontaktende (33, 34) unter Kraft oder Druck auf die Oberfläche (20a) des jeweiligen Kontaktbereichs (20 - 22) angedrückt wird.

13. Verfahren nach einem der vorangehenden Ansprüche,
bei welchem ein jeweiliges Kontaktelement (30-32) zunächst mittels einer Halte- und Positioniervorrichtung (60) gehaltert und positioniert wird und dann mittels der Sonotrode (50) das Fügen und Fixieren erfolgt.

14. Verfahren nach einem der vorangehenden Ansprüche,
bei welchem das jeweilige Kontaktende (33, 34) des Kontaktelements (30 - 32) an einer Stelle (X) oder an einem Punkt (X) als einzelnem Fußbereich (F) für die Strom- und/oder Potenzialübertragung kontaktiert wird.

15. Verfahren nach einem der vorangehenden Ansprüche,
bei welchem das jeweilige Kontaktende (33, 34) des Kontaktelements (30 - 32) an einer Mehrzahl Stellen (X1 - X3) oder an einer Mehrzahl Punkte (X1 - X3) als Mehrzahl Fußbereiche (F1 - F3) für die Strom- und/oder Potenzialübertragung kontaktiert wird.

16. Verfahren nach einem der vorangehenden Ansprüche,
bei welchem das jeweilige Kontaktelement (30 - 32) als ein Element aus der Gruppe ausgebildet wird, die besteht aus Kontaktdrähten, Bonddrähten, Litzen und Stanzteilen.

17. Verfahren nach einem der vorangehenden Ansprüche,
bei welchem das Kontaktelement (30 - 32) mit oder aus einem Material oder einer beliebigen Kombination von Materialien aus der Gruppe ausgebildet wird, die gebildet wird von Kupfer und Aluminium.

18. Verfahren nach einem der vorangehenden Ansprüche,
bei welchem das Kontaktende (33, 34) und/oder der Kontakt (41 - 43) mäanderförmig ausgebildet werden.

19. Verfahren nach einem der vorangehenden Ansprüche,
bei welchem der Kontaktbereich (20 - 23) als Pad ausgebildet wird.

20. Verfahren nach einem der vorangehenden Ansprüche,
bei welchem in der Nachbarschaft zu Kantenbereichen der Kontaktbereiche (20 - 23) beim Ultraschallschweißen eine Schweißrichtung und/oder Schwingungsrichtung verwendet wird, die im Wesentlichen parallel zur Richtung des jeweiligen Kantenbereichs verläuft, um ein Ablösen des Kontaktbereichs (20 - 23) am DCB-Substrat zu vermeiden.

## Claims

1. Method for the production of a power semiconductor module (1),
- in which a power semiconductor circuit (10) is formed with at least a first contact region (20 - 23) for contacting it electrically,
- in which further a contact element (30 - 32) having at least a first contact end (33, 34) is formed for contacting the power semiconductor circuit (10) electrically,
- in which at least the first contact end (33, 34) is connected mechanically and electrically to the first contact region (20 - 23) to form a first contact (40 - 43), and
- in which a respective contact (40 - 43) is formed via ultrasonic welding,
- wherein a sonotrode (50) used for the ultrasonic welding operation is also used to join the contact ends (33, 34) with the contact regions (20 - 22) and thus to join the contacts (40, 42), wherein massive copper or substantially copper-containing current taps are used as contact elements (30 - 32) with a material thickness between approximately 0.1 mm and approximately 3.0 mm and a current-carrying capacity between approximately 50 A and approximately 2000 A,
- wherein at least a part of the contact regions (20 - 22) is formed from a DCB substrate with a copper or a substantially copper-containing layer having a material thickness between approximately 0.1 mm and approximately 3.0 mm,
- wherein a ultrasonic welding power between approximately 300 W and approximately 10 kW is used,
- wherein a normal force on or for the sonotrode between approximately 500 N and approximately 3500 N is used as a joining force,
- wherein the first contact ends (33, 34) of the contact elements (30 - 32) are formed with energy direction indicators in the form of elevations at the first contact ends (33, 34) for better force alignment during ultrasonic welding, and wherein the energy direction indicators have at least one of the following:
a material thickness between approximately 0.05 mm and approximately 0.50 mm, preferentially between approximately 0.10 mm and approximately 0.20 mm;
a diameter between approximately 0.5 mm and approximately 4.0 mm, preferentially between approximately 1.0 mm and approximately 1.5 mm;
an area between approximately 0.2 mm² and approximately 12.5 mm², preferentially between approximately 0.8 mm² and approximately 1.8 mm².

2. Method according to claim 1,
wherein current taps with a material thickness between approximately 0.8 mm and approximately 1.5 mm are used.

3. Method according to one of the previous claims,
wherein current taps with a current-carrying capacity between approximately 300 A and approximately 2000 A, preferentially between approximately 300 A and approximately 1000 A are used.

4. Method according to one of the previous claims, wherein a DCB substrate with a copper or a substantially copper-containing layer having a material thickness between approximately 0.25 mm and approximately 0.6 mm is used.

5. Method according to one of the previous claims,
wherein the ultrasonic welding power lies between approximately 500 W and approximately 2 kW.

6. Method according to one of the previous claims,
wherein the frequency for the ultrasonic welding lies between approximately 20 kHz and approximately 35 kHz.

7. Method according to one of the previous claims,
wherein the energy for the ultrasonic welding lies between approximately 50 Ws and approximately 3 kWs, preferentially between approximately 50 Ws and 800 Ws.

8. Method according to one of the previous claims,
wherein the amplitude for the ultrasonic welding lies between approximately 15 µm and approximately 50 µm, preferentially between approximately 25 µm and approximately 35 µm.

9. Method according to one of the previous claims,
wherein the welding time for the ultrasonic welding lies between approximately 50 ms and approximately 2000 ms, preferentially between approximately 100 ms and approximately 500 ms.

10. Method according to one of the previous claims,
in which before the actual ultrasonic welding operation a calibration operation is carried out, in which a pressure is exerted simultaneously on a plurality of contact ends (33, 34) via the sonotrode (50) until all the energy direction indicators are contacted mechanically.

11. Method according to one of the previous claims,
in which the ultrasonic welding is carried out as a simultaneous multiple welding operation, in which simultaneously a plurality of contact elements (30 - 32) are contacted via a plurality of contact ends (33, 34), in particular with a respective current-carrying capacity between approximately 50 A and approximately 500 A.

12. Method according to one of the previous claims,
in which before the actual ultrasonic welding operation the sonotrode (50) is lowered onto the contact region (20 - 22) so that the respective contact end (33, 34) is thereby pressed under force or pressure onto the surface (20a) of the respective contact regions (20 - 22).

13. Method according to one of the previous claims,
in which a respective contact element (30 - 32) is first held and positioned via a holding and positioning device (60) and then the joining and fixing is carried out via the sonotrode (50).

14. Method according to one of the previous claims,
in which the respective contact end (33, 34) of the contact elements (30 - 32) is contacted at a location (X) or at a point (X) as an individual foot region (F) for the current and/or potential transmission.

15. Method according to one of the previous claims,
in which the respective contact end (33, 34) of the contact elements (30 - 32) is contacted at a plurality of locations (X1 - X3) or at a plurality of points (X1 - X3) as a plurality of foot regions (F1 - F3) for the current and/or potential transmission.

16. Method according to one of the previous claims,
in which the respective contact element (30 - 32) is formed as an element from the group consisting of contact wires, bonding wires, litz wires, and stamped parts.

17. Method according to one of the previous claims,
in which the contact element (30 - 32) is formed with or from a material or an arbitrary combination of materials taken from the group formed of copper and aluminium.

18. Method according to one of the previous claims,
in which the contact ends (33, 34) and/or the contact (41 - 43) are formed in a meandering shape.

19. Method according to one of the previous claims,
in which the contact region (20 - 23) is formed as a pad.

20. Method according to one of the previous claims,
in which in the vicinity the edge regions of the contact regions (20 - 23) during the ultrasonic welding a welding direction and/or an oscillation direction is used, which runs essentially parallel to the direction of the respective edge regions to avoid detachment of the contact regions (20 - 23) at the DCB substrate.

## Revendications

1. Procédé de fabrication d'un module semi-conducteur de puissance (1),
- dans lequel un circuit semi-conducteur de puissance (10) est formé avec au moins une première zone de contact (20 - 23) pour le mettre en contact électriquement,
- dans lequel de surcroît un élément de contact (30 - 32) est formé avec au moins une première extrémité de contact (33, 34) pour mettre le circuit semi-conducteur de puissance (10) en contact électriquement,
- dans lequel au moins la première extrémité de contact (33, 34) est connectée mécaniquement et électriquement avec la première zone de contact (20 - 23) pour former un premier contact (40 - 43), et
- dans lequel un contact respectif (40 - 43) est formé par soudage par ultrasons,
- dans lequel une sonotrode (50) utilisée pour l'opération de soudage par ultrasons est également utilisée pour joindre les extrémités de contact (33, 34) avec les zones de contact (20 - 22) et ainsi pour joindre les contacts (40, 42), des ramasseurs de courant en cuivre massif ou contenant essentiellement du cuivre étant utilisés comme éléments de contact (30 - 32) avec une épaisseur de matériau comprise entre environ 0,1 mm et environ 3,0 mm et une capacité de transport de courant comprise entre environ 50 A et environ 2000 A,
- dans lequel au moins une partie des zones de contact (20 - 22) est formée à partir d'un substrat DCB avec une couche en cuivre ou contenant essentiellement du cuivre ayant une épaisseur de matériau comprise entre environ 0,1 mm et environ 1,0 mm,
- dans lequel une puissance de soudage par ultrasons comprise entre environ 300 W et environ 10,0 kW est utilisée,
- dans lequel une force normale sur ou pour la sonotrode comprise entre environ 500 N et environ 3500 N est utilisée comme force d'assemblage,
- dans lequel les premières extrémités de contact (33, 34) des éléments de contact (30 - 32) sont formées avec des indicateurs de direction d'énergie en forme de soulèvements sur les premières extrémités de contact (33, 34) pour une meilleure orientation de force pendant le soudage par ultrasons, et dans lequel les indicateurs de direction d'énergie comprennent au moins un des éléments suivants :
une épaisseur de matériau comprise entre environ 0,05 mm et environ 0,50 mm, de préférence comprise entre environ 0,10 mm et environ 0,20 mm ;
un diamètre compris entre environ 0,5 mm et environ 4,0 mm, de préférence compris entre environ 1,0 mm et environ 1,5 mm ;
une surface comprise entre environ 0,2 mm² et environ 12,5 mm², de préférence comprise entre environ 0,8 mm² et environ 1,8 mm².

2. Procédé selon la revendication 1,
dans lequel des ramasseurs de courants ayant une épaisseur de matériau comprise entre environ 0,8 mm et environ 1,5 mm sont utilisés.

3. Procédé selon l'une des revendications précédentes,
dans lequel des ramasseurs de courant ayant une capacité de transport de courant comprise entre environ 300 A et environ 2000 A, de préférence comprise entre environ 300 A et environ 1000 A, sont utilisés.

4. Procédé selon l'une des revendications précédentes,
dans lequel un substrat DCB avec une couche de cuivre ou contenant essentiellement du cuivre ayant une épaisseur de matériau comprise entre environ 0,25 mm et environ 0,6 mm est utilisé.

5. Procédé selon l'une des revendications précédentes,
dans lequel la puissance de soudage par ultrasons est comprise entre environ 500 W et environ 2 kW.

6. Procédé selon l'une des revendications précédentes,
dans lequel la fréquence pour le soudage par ultrasons est comprise entre environ 20 kHz et environ 35 kHz.

7. Procédé selon l'une des revendications précédentes,
dans lequel l'énergie pour le soudage par ultrasons est comprise entre environ 50 Ws et environ 3 kWs, de préférence entre environ 50 Ws et environ 800 Ws.

8. Procédé selon l'une des revendications précédentes,
dans lequel l'amplitude pour le soudage par ultrasons est comprise entre environ 15 µm et environ 50 µm, de préférence entre environ 25 µm et environ 35 µm.

9. Procédé selon l'une des revendications précédentes,
dans lequel le temps de soudage pour le soudage par ultrasons est compris entre environ 50 ms et environ 2000 ms, de préférence entre environ 100 ms et environ 500 ms.

10. Procédé selon l'une des revendications précédentes,
dans lequel avant l'opération de soudage par ultrasons proprement dite une opération de calibrage est réalisée, au cours de laquelle on exerce simultanément une pression sur une pluralité d'extrémités de contact (33, 34) avec la sonotrode (50) jusqu'à ce que tous les indicateurs de direction d'énergie soient contactés mécaniquement.

11. Procédé selon l'une des revendications précédentes,
dans lequel le soudage par ultrasons est réalisé comme une opération de soudage multiple simultanée, au cours de laquelle une pluralité d'éléments de contact (30 - 32) est contactée simultanément via une pluralité d'extrémités de contact (33, 34), en particulier ayant respectivement une capacité de transport de courant comprise entre environ 50 A et environ 500 A.

12. Procédé selon l'une des revendications précédentes,
dans lequel avant l'opération de soudage par ultrasons proprement dite la sonotrode (50) est abaissée sur la zone de contact (20 - 22) de telle façon que l'extrémité de contact (33, 34) respective est pressée sous une force ou une pression sur la surface (20a) de la zone de contact respective (20 - 22).

13. Procédé selon l'une des revendications précédentes,
dans lequel un élément de contact (30 - 32) respectif est d'abord maintenu et positionné par un dispositif de maintien et de positionnement (60) et ensuite l'étape d'assemblage et de fixation est réalisée via la sonotrode (50).

14. Procédé selon l'une des revendications précédentes,
dans lequel l'extrémité de contact (33, 34) respective de l'élément de contact (30 - 32) est contactée à un endroit (X) ou à un point (X) comme unique zone de pied (F) pour la transmission de courant et/ou de potentiel.

15. Procédé selon l'une des revendications précédentes,
dans lequel l'extrémité de contact (33, 34) respective de l'élément de contact (30 - 32) est contactée à une pluralité d'endroits (X1 - X3) ou à une pluralité de points (X1 - X3) comme une pluralité de zones de pied (F1 - F3) pour la transmission de courant et/ou de potentiel.

16. Procédé selon l'une des revendications précédentes,
dans lequel l'élément de contact (30 - 32) respectif est formé comme un élément du groupe constitué par des fils de contact, des fils de liaison, des torons et des pièces de découpe.

17. Procédé selon l'une des revendications précédentes,
dans lequel l'élément de contact (30 - 32) est formé avec ou à partir d'un matériau ou d'une combinaison aléatoire de matériaux faisant partie du groupe formé par le cuivre et l'aluminium.

18. Procédé selon l'une des revendications précédentes,
dans lequel l'extrémité de contact (33, 34) et/ou le contact (41 - 43) est en forme de méandres.

19. Procédé selon l'une des revendications précédentes,
dans lequel la zone de contact (20 - 23) est un plot.

20. Procédé selon l'une des revendications précédentes,
dans lequel dans le voisinage de zones d'angle des zones de contact (20 - 23) pendant le soudage à ultrasons une direction de soudage et/ou une direction d'oscillation est utilisée, laquelle est essentiellement parallèle à la direction de la zone d'angle respective, afin d'éviter le détachement de la zone de contact (20 - 23) sur le substrat DCB.
